# EUROPEAN PATENT SPECIFICATION

(11) **EP 3 736 747 B1**
(45) Date of publication and mention of the grant of the patent: **23.09.2026**
(21) Application number: 19305594.4
(22) Date of filing: 09.05.2019
(51) Int. Cl.: G06N 10/40, G11C 11/56

(54) **QUANTUM MEMORY AND ASSOCIATED APPLICATIONS**
QUANTENSPEICHER UND ZUGEHÖRIGE ANWENDUNGEN
MÉMOIRE QUANTIQUE ET APPLICATIONS ASSOCIÉES

(43) Date of publication of application: 11.11.2020
(73) Proprietor: Cadet, Xavier, 75013 Paris (FR)
(72) Inventor: Cadet, Xavier, 75013 Paris (FR)
(74) Representative: Lavoix

(56) References cited:
- US-A- 5 323 344
- LORENA E ROSALENY ET AL: "Peptides as versatile scaffolds for quantum computing", 3 October 2017 (2017-10-03), pages 1 - 54, XP055651968, Retrieved from the Internet <URL:https://arxiv.org/pdf/1708.09440.pdf> [retrieved on 20191211]
- PETER HAMM: "Femtosecond IR Pump-Probe Spectroscopy of Nonlinear Energy Localization in Protein Models and Model Proteins", JOURNAL OF BIOLOGICAL PHYSICS, KLUWER ACADEMIC PUBLISHERS, DO, vol. 35, no. 1, 21 February 2009 (2009-02-21), pages 17 - 30, XP019680427, ISSN: 1573-0689

## Description

### TECHNICAL FIELD OF THE INVENTION

The present invention concerns a quantum memory. The present invention also relates to an associated quantum computer. The present invention also concerns a method for storing information in a quantum memory. The present invention also relates to an associated use. The present invention further concerns a method for screening polypeptides.

### BACKGROUND OF THE INVENTION

Classical computing relies on calculations carried out on several entities exhibiting several states. In such classical context, such physical entities are named "bits" and have only two states, usually named 0 and 1. The calculations are made by manipulating the two states of each bit.

By contrast, quantum computing relies on operations carried out on a sequence of physical entities named a sequence of qubits (short for quantum of bits). Although each qubit also has two states as a bit, quantum mechanics allows each qubit to be in a coherent superposition of both states simultaneously. The calculations are therefore made by manipulating more than two states for each physical entity, resulting in a higher potential for algorithm relying on such calculations.

Any two-level quantum-mechanical system can be used as a qubit. Multilevel systems can be used as well provided two states can be manipulated individually.

As an incomplete list of quantum-mechanical system, one can cite photons, ions, electrons, nucleus, Josephson junctions or quantum dots.

As a specific example, for photons, several vectors can be used as states. Notably, experiments have been carried out based on the number of photons as states (presence of one photon or absence of photon) or based on the polarization states of the photons.

However, quantum decoherence limits the quantum behavior of such quantum-mechanical systems. Quantum decoherence corresponds to interaction of the quantum mechanical system with the environment, notably environment residual noise and collisions with a particle of the environment.

As the environment noise and the probability of a collision decreases with temperature, such quantum-mechanical systems are often used at cryogenic temperatures.

This means that none of these systems are adapted to operate at physiological temperatures, that is temperatures comprised between 35°C and 40°C, in particular comprised between 36°C and 38°C. The article Lorena E Rosaleny ET AL: "Peptides as versatile scaffolds for quantum computing", 3 October 2017, pages 1-54, https:// arxiv.org/pdf/1708.09440.pdf, pertains to qubits comprising at least one polypeptide comprising at least one alpha helix secondary structure.

### SUMMARY OF THE INVENTION

There is therefore a need for a quantum memory adapted to operate at physiological temperatures.

To the end, the specification proposes a quantum memory according to claim 1.

According to further aspects of the invention, which are advantageous but not compulsory, the quantum memory might incorporate one or several of the features of claims 2 to 6, taken in any technically admissible combination.

The specification also relates to an apparatus, notably a quantum computer, comprising at least one quantum memory as previously described.

### BRIEF DESCRIPTION OF THE DRAWINGS

The invention will be better understood on the basis of the following description which is given in correspondence with the annexed figures and as an illustrative example, without restricting the object of the invention. In the annexed figures:
- figure 1 shows an example of a quantum memory.
- figure 2 shows an alpha helix secondary structure.
- figure 3 shows a diagrammatic representation of the molecular network that constitutes an alpha helix which illustrates that the molecular network can be decomposed into three 1D subnets of interconnected hydrogen bonds.
- figure 4 illustrates the pathways involved in a model of visual processing: postrhinal cortex (POR) gets information about moving objects via a parallel visual pathway from an evolutionarily ancient brainstem area called superior colliculus. The two parallel visual pathways are routed through distinct relay stations in a brain structure called the thalamus: dLGN (dorsolateral geniculate nucleus) for V1 and the Pulvinar for POR (adaption of a figure from Massimo Scanziani's laboratory, University of California San Francisco).

### DETAILED DESCRIPTION OF SOME EMBODIMENTS

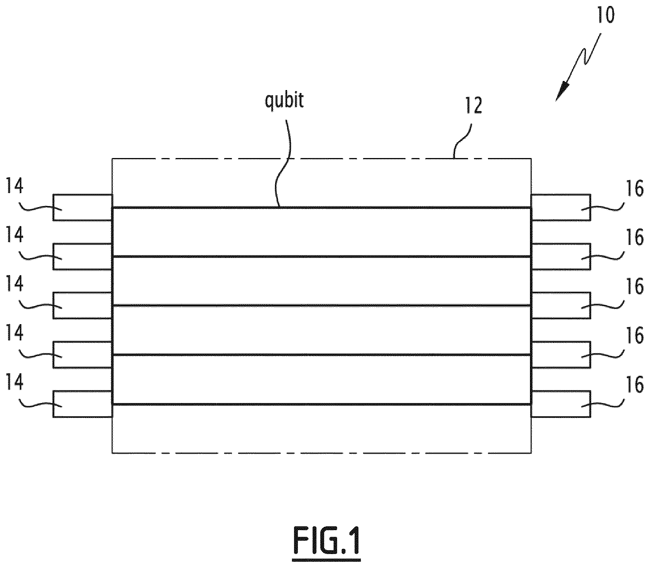

Figure 1 illustrates schematically a quantum memory 10.

A quantum memory is an electronic device which is adapted to store several data. The quantum memory 10 comprises a memory space 12 and, optionally, a writing unit 14 and a reading unit 16.

The memory space 12 is a set of qubits.

In the present example, the qubits consist of polypeptides comprising at least one alpha helix (α-helix) secondary structure.

A polypeptide chain is formed by a succession of amino acid (AA) residues -NH- Cα-CO- linked by peptide bonds. The number of amino acids in a polypeptide is at of least two, and may comprise several hundreds or thousands of amino acids. For a polypeptide to comprise at least one α-helix, the polypeptide must be at least 4 amino acid long. Preferably, the polypeptide is at least 10, 20, 30, 40, or 50 amino acid long. In certain embodiments, the polypeptide comprises at most 1000 amino acids, e.g.; at most 500, 400, 350, 300, 250, 200, 150, 100 or 50 amino acids.

Based on the primary structure of a polypeptide (i.e. the sequence of amino acids constituting the polypeptide chain), the person skilled in the art can readily determine if the polypeptide comprises secondary structures, i.e. α-helix and/or β-sheets, by using a protein structure prediction software, such as open source softwares like PEP-FOLD3 (http://bioserv.rpbs.univ-paris-diderot.fr/services/PEP-FOLD3/) or PSIPRED 4.0 (Predict Secondary Structure, http://bioinf.cs.ucl.ac.uk/psipred_new/).

According to an embodiment, the polypeptide comprising at least one α-helix secondary structure further comprises β-sheets. According to another embodiment, the polypeptide comprising at least one α-helix secondary structure does not comprise β-sheets. The presence of β-sheets in the polypeptide comprising at least one α-helix secondary structure is irrelevant on the qubit state.

In the example which is described, the ratio between the number of qubits which are a polypeptide comprising at least one alpha helix secondary structure and the total number of qubits is superior or equal to 70%.

In such example, each states of the qubit are the vibration states of the amide-I mode which corresponds to a stretching of the C = O bond.

Alternatively or in complement, each states of the qubit are the vibration states of the amide-A mode which corresponds to a stretching of the N-H bond.

Examples of polypeptides comprising at least one alpha helix secondary structure include Plannexin (SEQ ID NO:1), FGL (SEQ ID NO:2), peptide P2 (SEQ ID NO:3), Diptericin B (SEQ ID NO:4), PTEN-PDZ (SEQ ID NO:5), GNBP-Like3 (SEQ ID NO:6), Peptide 6 (SEQ ID NO:7), PTD4-Pl3KAc (SEQ ID NO:8), Substance P (SEQ ID NO:9), Somatostatin (SEQ ID NO:10), Vasoactive intestinal peptide (SEQ ID NO :11), pituitary adenylate cyclase-activating polypeptide (SEQ ID NO :12), Calcitonin gene-related peptide (SEQ ID NO :13), Ghrelin (SEQ ID NO :14), Obestatin (SEQ ID NO :15), Neuro-peptide S (SEQ ID NO:16), and Cocaine- and amphetamine-regulated transcript peptide (SEQ ID NO :17). These polypeptides are associated with maintenance, restoration or improvement of cognitive processes, in particular learning and memorization processes.

The set of qubits comprises less than 100 qubits, preferably less than 20 qubits. This means that the total number of qubits in the memory space 12 is inferior or equal to 100 qubits, preferably inferior or equal to 20 qubits.

In a specific embodiment, the set of qubits comprises more than 2 qubits, preferably more than 10 qubits.

According to an embodiment, the set of qubits comprises several identical pairs of qubits. This provides the memory space 12 with symmetry properties.

The writing unit 14 is adapted to write data on each qubit.

More precisely, the writing unit 14 is adapted to convert data in a combination of states of at least one qubit.

This notably means that the writing unit 14 is adapted to modify the vibrational states of the qubits.

For instance, the writing unit 14 is an electrical application unit.

In such case, the electrical application unit is adapted to encode data in one or several qubits in the form of electrical pulses.

The electrical pulses are adapted to change the vibrational states of at least one qubit so as the vibrational states of the at least one qubit correspond to the data to be stored.

More generally, the writing unit 14 is an electronic circuitry.

The reading unit 16 is adapted to read the vibrational state of each qubit.

This notably means that the reading unit 16 is adapted to determine the vibrational states of the qubits.

The reading unit 16 is, for instance, a voltmeter.

In such case, the voltmeter enables to detect the voltage of the qubits.

The voltage of each qubit enables to determine the state of each qubit.

More generally, the reading unit 16 is an electronic circuitry.

Knowing the state of each qubit enables to access to the data which is stored in the memory space 12.

The operating of the quantum memory 10 is now described in reference to a method of storing data in a quantum memory 10, the method not covered by the scope of the claims.

The method of storing comprises a step of writing and a step of reading.

At the step of writing, a data is written by the writing unit 14 on the quantum space 12.

The quantum memory 10, and more specifically the quantum space 12, stores the data.

Explanations of the abilities of transferring information of polypeptides in the alpha helix configuration from the writing unit 14 to the reading unit 16 are provided in the appendix.

When it is desired to access the data, the step of reading is carried out by using the reading unit 16.

The reading unit 16 measures the value of the qubits of the quantum space 12.

In the present case, the value is expressed in volts.

The values enable to access to the state of each qubit.

The state of each qubit is then converted by the reading unit 16 in the data to be stored.

The quantum memory is thus adapted to store data in a quantum memory 10 without requiring a chilled enclosure.

The claimed quantum memory 10, and more precisely the quantum properties of a polypeptide comprising at least one alpha helix configuration, may be used for numerous applications.

As an application, the quantum memory 10 is used in a quantum computer.

According to an embodiment, the polypeptide has been previously characterized as comprising an alpha helix secondary structure by structural modelling, e.g. by using a protein structure prediction software, and has been selected on the basis of this characterization.

According to another embodiment, the polypeptide has been previously characterized as having the capacity to bind to one or more specific regions of the brain, such as the visual cortex or the postrhinal cortex, and has been selected on the basis of this characterization.

The polypeptide comprising at least one alpha helix secondary structure is preferably different from Plannexin (SEQ ID NO:1), FGL (SEQ ID NO:2), peptide P2 (SEQ ID NO:3), Diptericin B (SEQ ID NO:4), PTEN-PDZ (SEQ ID NO:5), GNBP-Like3 (SEQ ID NO:6), Peptide 6 (SEQ ID NO:7), PTD4-Pl3KAc (SEQ ID NO:8), Substance P (SEQ ID NO:9), Somatostatin (SEQ ID NO:10),, Vasoactive intestinal peptide (SEQ ID NO :11), pituitary adenylate cyclase-activating polypeptide (SEQ ID NO :12), Calcitonin gene-related peptide (SEQ ID NO :13), Ghrelin (SEQ ID NO :14), Obestatin (SEQ ID NO :15), Neuro-peptide S (SEQ ID NO:16), and Cocaine- and amphetamine-regulated transcript peptide (SEQ ID NO :17).

### APPENDIX

A polypeptide chain consists of a succession of amino acid residues - NH - C_{α} - CO - linked by peptide bonds, where the C_{α} are the carbon carriers of the lateral chains. Due to the rigidity of the peptide bond, the structure of a chain is characterized by the successive orientation of the different planes of the CO - NH amide groups.

The establishment of hydrogen bonds in a chain is decisive for the stability of its structure and when the number of bonds established between residues of the same protein is maximal, two main secondary structures emerge: β-sheets and the α-helix.

The α-helix secondary structure corresponds to a periodic winding of the chain into a straight helix so that the α-helix are quasi-unidimensional (1D) structures.

β-sheets consist of several β-strands, stretched segments of the polypeptide chain kept together by a network of hydrogen bonds. Unlike the α-helix, the β-sheet is formed by hydrogen bonds between protein strands, rather than within a strand.

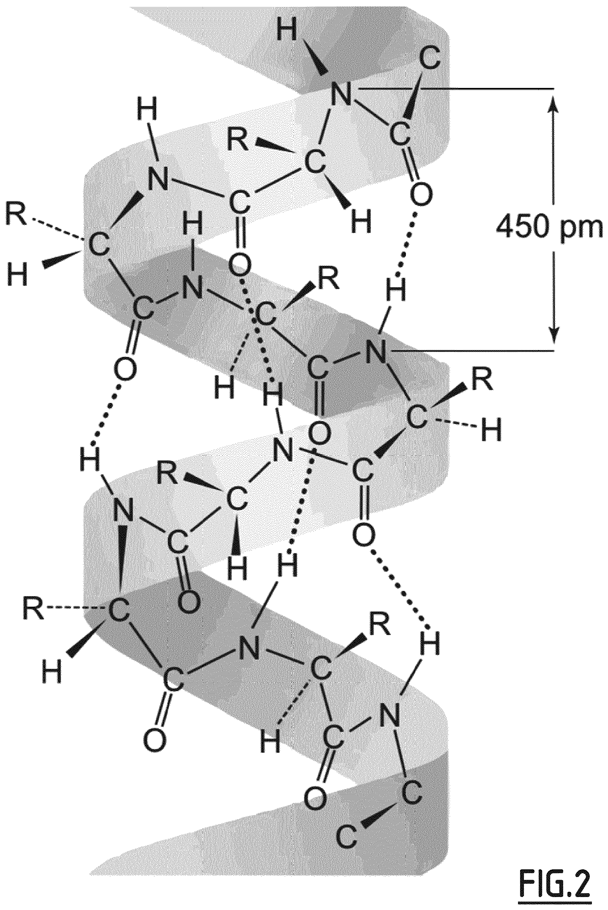

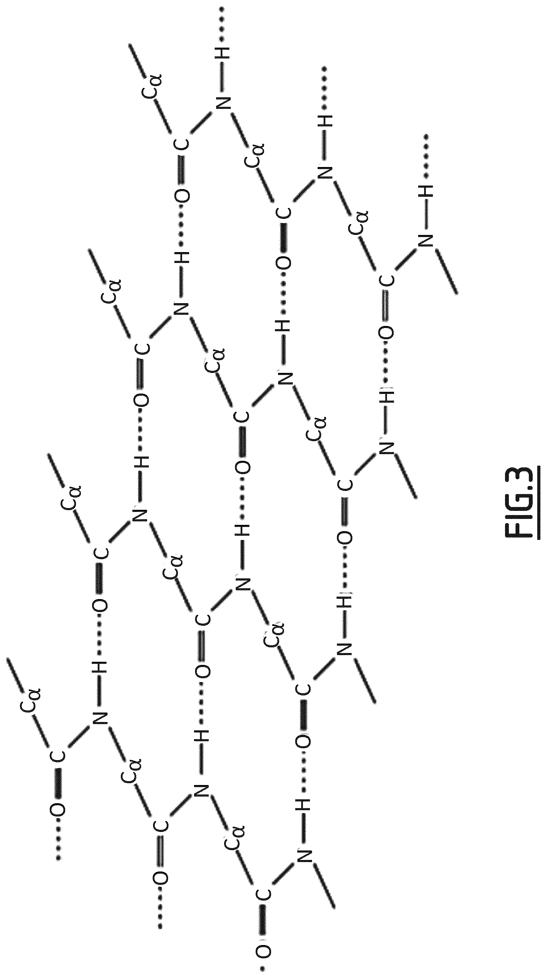

A α-helix is a structure formed by the winding of 3.6 amino acid residues per helix turn and a translation of 1.5 angstroms per residue along the axis of the helix or a translation of 5.4 angstroms per revolution (Figure 2). In such a configuration, the carbonyl group of each peptide residue is bound by a hydrogen bond with the amine group of the next fourth residue. When considering the amide grouping centered around the rigid peptide bond, each amide group is bound by a hydrogen bond with the third next amide group. Thus, a α-helix can be represented as the nesting of three hydrogen bond chains (Figure 3).

In a traditional representation, the upper C_{α} carbons are directly related to the lower N nitrogen shifted from an amide group to the right. Thus, each amide group is linked, on the one hand, to the two closest neighboring amide groups through C_{α} carbons and, on the other hand, to the third closest neighboring amide groups through a hydrogen bond. Therefore, the molecular network of an α-helix can be decomposed into three 1D subnets of interconnected hydrogen bonds (Figure 3).

The transport of vibrational energy in α-helix can be achieved through two main modes: the amide-I mode essentially corresponding to the stretching of the C = O bond and the amide-A mode associated with the stretching of the N - H bond. This transport is dominated by nonlinear phenomena linked to on one hand the part of intramolecular anharmonicity and on the other hand the strong coupling with the low-frequency modes of the helix skeleton. In this context, the hydrogen bond that governs the helix structure plays a predominant role. Indeed, since hydrogen bond connects the amide groupings of the same subnet, it promotes the emergence of nonlinear effects in each subnet.

Thus, as a first approach, it can be studied the vibrational transport within a single subnet by modeling the dynamics in the α-helix as a unidimensional network containing N amide groups linked by a set of hydrogen bonds.

Such study reveals a certain complexity which results from a competition between three physical phenomena which are now described.

The first physical phenomenon is the dipolar coupling between the amide groups and the hydrogen bonds. This corresponds to the propagation of vibrational excitons in the network as a series of plane waves. Such excitons are called vibrons and can be construed as quasi-particles associated with the collective dynamics of intramolecular vibrations. Due to the dipolar coupling, such vibrons are thus delocalized.

Another physical phenomenon is the appearance of bound states due to the anharmonicity of the intramolecular potential of each mode. These states are defined by a location of the inter-distance vibronic so that the vibrons are trapped towards each other. As in parallel, invariance by translation causes a delocalization of the center of mass of the vibrons which behaves like a plane wave, these bound states behave like classical solitons in non linear systems.

The third physical phenomenon which is involved is the interaction between high frequency internal modes and low frequency external vibrations (phonons). Such interaction modifies the nature of vibronic states. By this interaction, the presence of a vibron induces a local deformation of the network that instantly follows the propagation of the vibron. A vibron dressed by a deformation then forms a "small polaron". This cladding mechanism, which is the quantum equivalent of conventional auto-trapping, disrupts the vibrational dynamics in two processes. First, it decreases the jump constants and reduces the delocalization ability of the polarons. Secondly, it is a second source of non-linearity and promotes non-local interactions between polarons responsible for the formation of particular bound states.

By modeling such competition between these three phenomena in the frame of a system in thermodynamic equilibrium for the phonons, it appears that the system can be considered as described by a generalized Hubbard's Hamiltonian for bosons.

With such formalism, it can be shown that a α-helix configuration emits vibrons at the level of each set of amide groups. The vibrons preferentially interact with the low frequency acoustic phonons associated with the collective external motions of the amide groups.

In addition, with the help of the previously mentioned one-dimensional model, two types of bound states can be formed depending on the competition between the second and the third physical phenomena. The low frequency bound states form a band below the continuum of free states and mainly characterize two polarons located on the same location. By contrast, high-frequency bound states are able to resonate with the continuum and correspond to the case of two polarons trapped at two nearest neighbor locations.

Beyond the mean field approximation, the analysis of the influence of the polaron-phonon coupling has shown that the relaxation of the bi-polaronic states takes place on a time of the order of the pico-second.

Moreover, the low-frequency bound states undergo a transition towards the high-frequency bound states. By comparison, the high-frequency bound states decay in both the low-frequency bound states and the free-state continuum. Finally, under the action of phonons, free states make transitions within the continuum associated with them.

The calculation of the time-resolved pump-probe spectra revealed that bound states have a specific signature. Indeed, the free states contribute to the formation of a negative peak whereas a bound state favors the presence of a positive peak. Since the position of such a peak is indicative of the energy of the probed bound state, considering the collective, nonlinear nature of the intramolecular vibrations is essential to correctly understand the spectrum.

It has also been shown the existence of a transition between two dynamic regimes by using a three-dimensional model instead of the one-dimensional model.

At low temperatures, the inter-network jump constants play a crucial role and the polaronic and bi-polaronic states have an important three-dimensional character.

At biological temperature, the dressing mechanism promotes intra-network jumps so that the polarons can only propagate in a single sub-network. Quantum states lose their three-dimensional nature and can be well described by the one-dimensional model.

Such properties make of polypeptide in α-helix configuration good candidate for transporting vibrons.

A first theory was proposed to support such assertion. Such quantum theory explains how energy could be transported along α-helix secondary structure of proteins. The idea is that a protein is a biopolymer formed from only 20 monomers. These monomers are α-amino acids which unite with peptide bonds to give long polypeptide chains. These chains, wound helically, have a quasi-periodic structure along which are distributed peptide units H-N-C = O connected to each other by hydrogen bonds. Because of the geometry of the protein, these peptide units form three molecular chains parallel to the axis of the helix. A particular chain thus represents a one-dimensional molecular network formed by a succession of peptide units containing the C = O group. From a vibrational point of view, stretching of the C = O bond characterizes a normal high frequency mode called amide-I mode.

Such theory gives a privileged role to the C = O modes. Indeed, when an ATP (Adenosine triphosphate) molecule binds to a particular site of the protein, it interacts with the water molecules in the medium and releases energy, which, by resonant coupling, is converted into internal vibration excitation of a C = O bond of a particular peptide unit. The dipolar interaction between the neighboring C = O groups results in the delocalization of the internal vibration and the formation of a vibrational exciton, the vibron, at the origin of energy transport in the α-helix.

This first theory was improved and now corresponds to a Soliton Pang's Model. Notably, it has been shown that the soliton generation, propagation, and stability are dependent on the symmetry of the exciton-phonon Hamiltonian interaction and the initial location of application of the exciton energy.

These theories show that, in alpha-helix configurations, the amide-I vibron associated with the propagation of C = O vibrations along the polypeptide is playing a key role in transporting the energy released by the hydrolysis of ATP and in the conversion of this chemical energy into mechanical work.

In other words, this means that qubits can be encoded on molecular vibrations. Information is conveyed by the vibrational quantum. Vibrational excitons (vibrons) therefore appear to be good candidates for transferring quantum information along molecular networks and notably polypeptide.

The mechanism of such vibronic transfer is believed to rely on random walk on a network.

Before detailing the implications of such theory, generalities are provided on random walk on a network and the implementation of such concept in the frame of quantum mechanics.

Random walking is a theoretical concept requiring only two elements: a walker and a network. The walker can be construed as a moving object capable of moving according to probabilistic laws. The network, consisting of a set of connected nodes, plays the role of medium for walking. When two nodes of the network are connected, a link is established between them so that the walker can jump from one to the other.

Such concept of random walking in a network enables to describe several known phenomena, such as Brownian movement or diffusion phenomena describing the motion of molecules or atoms on surfaces.

This concept is also used in algorithmic notably in the Monte Carlo algorithms.

The analogous model in the quantum physics of the concept of random walking in a network is named quantum walk. In such model, the walker is no longer considered as a classical mobile but as a quantum object whose dynamics is governed by the Schrödinger equation.

Whether they are electronic in nature, such as Frenkel excitons, or vibrational, like vibrons, excitons act on molecular networks as these elements following the Schrödinger equation. The excitons behave like real quantum walkers capable of conveying energy or even information.

The dissipative excitonic quantum walk on complex molecular networks has been studied and the emergent properties in the case of a transfer of quantum information carried out by an exciton evolving on a complex molecular network in the presence of local phonons have also been analyzed.

For this, a model of the complex molecular network has been proposed by focalizing on the presence of phonons and more specifically on the quantum decoherence that exciton-phonon entanglement can cause in the case of the transfer of a superimposed excitonic state.

Such approach can be followed by working directly on the general Hamiltonian of the system using a quasi-degenerate perturbative operator approach. This method allows to completely reformulate the exciton-phonon problem on network through the expression of an effective Hamiltonian encoding two types of dressing process.

The first process describes the wrapping of the exciton by a virtual phonon cloud. This phenomenon is reflected in the redefinition of the excitonic eigenstates.

The second process represents the appearance of phonons by excitonic virtual transitions. In this frame, it was observed that this second dressing description of phonons corresponds to a new operator representating phononic transport processes. In other words, unlike naked phonons that describe localized vibrations, dressed phonons are able to relocate resulting in the appearance of extended modes.

Based on this formalism, one can then derive the behavior of excitons in such system.

In particular, the dressing of the exciton essentially results in a redefinition of the undisturbed excitonic eigenvalues in energy. This property is the signature of the fact that the exciton behaves like a polaron. In other words, the exciton cannot be considered as free particle because of the interaction with the phonon cloud that surrounds the exciton.

The properties of the new extended phononic modes originate from the symmetric of the network.

These properties make it possible to interpret all the singular characteristics observed in the excitonic dynamics. At short times, the polaric behavior explains why the dynamics is slowing down strongly. At long times, the emergence of a non-Markovian dynamic is linked to the temporal evolution of each extended phononic mode. In particular, this shows that the knowledge of the excitonic eigenvalues represented a key data to interpret the evolution of decoherence, but also the appearance of quantum super-recurrences of information. These results reveal that the symmetry of a complex network could play a fundamental role in the survival of information.

Such approach is limited in so far as when an exciton evolves on a molecular network, the exciton will naturally tend to undergo the effects of its environment. In the context of molecular networks, phonons, quantum particles resulting from the quantification of network vibrations, represent the first environmental elements with which an exciton interacts the most. Thus, to describe an excitonic quantum walk realistically, a more accurate approach is to consider an exciton as an open system interacting with an environment.

In this context, studies have been conducted to quantify to what extent this environment could influence the smooth progress of an excitonic quantum walk. Such analysis shows that the presence of a purely phase-shifting environment could significantly improve excitonic network transport processes. Notably, in the context of excitonic quantum walk, the subtle mixture between coherent propagation mechanisms (free evolution), and incoherent jump processes (energy exchanges with phonons) could make it possible to generate a hybrid quantum transport ultra efficient. Thus, contrary to what one could think, the processes of quantum decoherence present in the frame of realistic excitonic transport could have an unsuspected beneficial effect.

At short and intermediate times, the effects of exciton-phonon interaction essentially result in the appearance of a quantum decoherence process. Under these conditions, the excitonic system gradually loses its ability to develop superimposed quantum states, and the quantum information initially encoded is destroyed.

However, it has been shown that this process of quantum decoherence is only apparent. Indeed, the exciton-phonon system never completely loses the memory of its initial state so that the information can resurface after a certain time.

Early indications of these strongly non-Markovian behaviors have been observed in a low-temperature regime. The study of these behaviors then made it possible to observe, surprisingly, the appearance of long-time quantum super-recurrences at low and high temperatures.

In addition, it appears that the period of quantum recurrence is independent of temperature, but dependent on the coupling parameter: the temperature does not influence the period of appearance of these peaks, but mainly amplifies the amplitudes of the recurrences at short term.

The existence of super-recurrences clearly demonstrates that the non-Markovian dynamics can allow, over very long times, to find the information initially encoded. In other words, contrary to what one might imagine, the process of decoherence is not irreversible.

In other words, this means that this collapse of coherence is clearly not irreversible. Indeed, partial or even total quantum recurrences can appear as long as a long time is waited.

In reality, the physical origin of this phenomenon is related to two distinct elements: the smallness of the studied network and the degeneration of phononic pulsations.

When one considers a finite size network, the number of degrees of freedom of the phononic environment becomes limited so that the various phase terms acting in the calculation of the decoherence factor are very few.

Moreover, the symmetry of the network produces a degeneracy of order N ≠ 1 of Bloch phonon pulsations: there are then only two types of phase terms acting in the calculation of the decoherence factor.

At short times, these terms will admit a phase shift and cause a drop in the decoherence factor. However, at long times, the reduced number of modes favors the appearance of time windows during which the averaged terms can again evolve in phase.

These moments of re-phasing then produce quantum recurrences synonymous with the fact that the exciton-phonon system returns to a state close to its initial state. The system does not lose the memory of its past states: this is the signature of a non-Markovian behavior.

Thus, efficient transfers of information despite the presence of phonons become possible thanks to the appearance of quantum recurrences, in polypeptides comprising an α-helix.

Furthermore, the vibration states amine-A mode, which corresponds to the stretching of the N-H bonds, in alpha helix has been observed. Edler et al. (2004, PHYSICAL REVIEW LETTERS, vol 93, 10, 124-127) showed that "femtosecond infrared pump-probe spectroscopy of the N-H mode of a stable alpha-helix reveals two excited-state absorption bands, which disappear upon unfolding of the helix. A quantitative comparison with polaron theory shows that these two bands reflect two types of two-vibron bound states connected to the trapping of two vibrons at the same site and at nearest neighbor sites, respectively. The latter states originate from an acoustic phonon in the helix, which correlates adjacent sites". The experimental results unambiguously show that the two positive bands are a signature of the helical conformation, in which individual N-H vibrations are correlated by acoustic phonons. The phonons enable the formation of self-trapped states that can be identified through their anharmonicity. When the helical structure is destroyed, the correlation vanishes and the experimentally observed pump-probe response is that of an isolated vibrator. The theory assigns the two positive peaks to the existence of two kinds of two-vibron bound states correspond to the trapping of two vibrons at the same site and at nearest neighbor sites, respectively. The latter states originate from the overlap between a virtual cloud of acoustic phonons with each vibron. This is a direct observation of vibrationally self-trapped states in alpha-helices.

### Cognitive processes, learning and memorization are possible thanks to the alpha-helices of polypeptides

Different studies in the field of neuroscience relate to the better understanding of cognitive mechanisms, learning and memorization in the short and/or long term.

An extensive review of the literature has been conducted to identify documents associating polypeptides and cognitive mechanisms.

Table 1 identifies polypeptides described in the prior art as having a positive effect on the maintenance, restoration or improvement of these processes. The polypeptides were either injected into the brain, or had their expression induced or expression level increased. Through a modeling of the secondary structure of these polypeptides, we have established that each of the polypeptides comprises an alpha-helix.

Conversely, other polypeptides for which no effect on cognitive mechanisms was reported, or, worse, for which the polypeptide was shown to be detrimental for cognitive mechanisms were found, by modeling of their secondary structure, to lack alpha helix.

For instance, while Diptericin B and another immune peptide (Gram-Negative Bacterial Binding Protein like 3; GNBP_like3) were found to modulate long-term memory by Barajas-Azpeleta et al. (2018, PLoS Genet 14 (10): e1007440), this was not the case for AttacinB as the authors note "[s]urprisingly, even though upregulation of AttacinB was strongly co-related with long-term memory, an expression of AttacinB RNAi in either the body fat or neurons did not interfere with memory.".

In addition, Kohler et al. (Kohler LB, Christensen C, Rossetti C, Fantin M, Sandi C, Bock E, Berezin V (2010) Eur J Cell Biol 89: 817-827) showed that dennexinA odd memory retention.

Finally, Beta-Amyloid 42 (Aβ42) is known to play a pivotal role in the pathogenesis of Alzheimer's disease, because of the aggregative ability and neurotoxicity of Aβ42 are greater than those of Aβ40 (A. Morimoto et al., J. BIOL CHEM. 279, No. 50, Issue of December 10, pp. 52781-52788, 2004.). They are involved in Lewy bodies dementia too. ID Limon et al. (Neuroscience Research 63 (2009) 129-137) demonstrated that Aβ (25-35) injected into the hippocampus of rats causes a detriment to the spatial memory.

From the foregoing, it can be observed that whenever a peptide is described as having a role related to memory, it contains an alpha-helix, while polypeptides reported to have no or detrimental effect lack an alpha-helix.

**Table 1: polypeptides described as having positive effect on the maintenance, restoration or improvement of cognitive mechanisms, learning and memorization in the short and/or long term.**

| **Peptide** | **Sequence*** | **# of AA** | **Mw (Da)** | **Localisation of injection/ expression** | **Model** | **Effects** | **Presence of Alpha Helix** | **Reference** |
|---|---|---|---|---|---|---|---|---|
| Plannexin | DVRRGIKKTD (SEQ ID NO :1) | 10 | 1187.36 | right lateral cerebral ventricle | Rat | Enhancement of learning/ memory, improvement of spatial learning | Y | Kraev et al. (2011) PLoS ONE 6(8): e23433. |
| FGL | EVYVVAENQQGKSKA (SEQ ID NO :2) | 15 | 1649.81 | right lateral ventricle (Corbett, Dallerac); Intra-cerebroventricular | Rat | Enhancement of cognition, spatial learning and memory, social memory | Y | Cambon K et al. (2004) J. Neurosci 24:4197-4204 ; |
| | | | | | | | | Knafo S et al. (2012) PLoS Biol 10:e1001262 ; |
| | | | | | | | | Corbett NJ et al. (2013) PLoS ONE 8:e71479 |
| Peptide P2 | GRILARGEINFK (SEQ ID NO :3) | 12 | 1373.61 | intra-cerebroventricular | Rat | Enhancement of short-term memory, Protection against scopolamine-induced amnesia | Y | Rizhova L et al. (2007) Neuroscience 149(4):931-42, |
| Diptericin B | | 120 | 13141.58 | expression in the head fat body | *Drosophila* | regulation of long-term memory | Y | Barajas-Azpeleta R et al. (2018) PLoS Genet 14(10): e1007440. |
| PTEN-DPZ | DSDPENEPFDEDQHTQITKV (SEQ ID NO :5) | 20 | 2344.37 | lateral ventricles | Rat | enhancement of learning and memory | Y | D. Asua et al., (2018) Neuroscience 370 81-87 |
| GNBP-Like3 | | 152 | 17130.82 | expression in the central brain | *Drosophila* | regulation of long-term memory | Y | Barajas-Azpeleta R et al. (2018) PLoS Genet 14(10): e1007440. |
| Peptide 6 | VGDGGLFEKKL (SEQ ID NO :7) | 11 | 1162.34 | blood-brain barrier permeable | Mouse | enhancement of learning and memory | Y | M. O. Chohan et al. Neurosurgery. 2015 February; 76(2): 201-215. |
| PTD4-PI3KAc | YARAAARQARAGSDGGYMDM (SEQ ID NO :8) | 20 | 2118.32 | lateral ventricles | Rat | enhancement of learning and memory | Y | D. Asua et al., (2018) Neuroscience 370 81-87 |
| Substance P (Tachykinins) | RPKPOOFFGLM (SEQ ID NO:9) | 11 | 1349.26 | lateral hypothalamus or the medial nucleus of the septum, | Mice | enhancement of learning and memory () | Y | Schlesinger, K. et al., 1986. Behav. Neural. Biol. 45, 230-239; |
| | | | | | | | | Huston J. P. and U. Staubli,. Bchav Neural Biol 27: 244-248, 1979; |
| | | | | | | | | Staubli. U. and J. P. Huston, Pharmacol Biochcm Behav 10: 783-786, 1979 |
| | | | | | | | | Staubli. U. and J. P. Huston, Behav Brain R 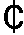 's I: 245-255, 1980 |
| Somatostatin | AGCKNFFWKTFTSC (SEQ ID NO:10) | 14 | 1637.88 | intra-cerebroventricular | Rat-Mice | Several animal studies demonstrated the correlation between somatostatin level and memory performance | Y | Vécsei L. at al., 1983, Peptides 4, 293-295; Nakagawasai, O. et al, 2003, Behav. Brain Res. 142, 63-67. |
| VIP (Vasoactive intestinal peptide) | | 28 | 3325.8 | intra-cerebroventricular | Rat | ameliorating effect on spatial cognitive deficits induced | Y | Yamaguchi, Y., Kobayashi, H., 1994, Neuropeptides 26, 153-158. |
| | | | | microinjection into the right hippocampal CA1 area | Rat | positive effect on learning and memory | | Ivanova M., et al., Psychopharmacology, 2012, Volume 221, Number 4, Page 561, |
| PACAP (pituitary adenylate cyclase-activating polypeptide) | | 27 | 3147.62 | intra-cerebroventricular | Rat | enhancement of memory in rats | Y | Sacchetti, B. et al., 2001, Neurobiol. Learn. Mem. 76, 1-6; |
| CGRP (Calcitonin gene-related peptide) | | 30 | 3127.6 | intra-cerebroventricular | Rat | - attenuation of learning impairment (Bouchard & al., 1997) | Y | Bouchard, P., et al., 1997, Eur. J. Neurosci. 9, 2142-2151; |
| | | | | | | - amelioration of the performance in the passive avoidance test (Kovács and Telegdy, 1994; Borbely & al. 2013 ) | | Kovács, A., Telegdy, G., 1994, Peptides 15, 893-895; Éva Borbély et al., Neuropeptides 47 (2013) 439-450 |
| Ghrelin | | 25 | 3370.9 | intra-cerebro-ventricular and infusions in specific brain regions infusion in the hippocampus | | increase memory retention | Y | Carlini VP et al., Biochem Biophys Res Commun. 2004;313:635-641 ; |
| | | | | | | enhancement of spatial memory | | Chen L. et al, Eur J Neurosci. 2011 ;33:266-275; |
| | | | | Intra-amygdaloid micro-injection | | enhancement of learning processes and memory | | Toth K, et al., Behav Brain Res. 2009;202:308- 311 |
| Obestatin | | 23 | 2516.3 | intra-cerebro-ventricular | Rat | improvement of memory performance. Improvment of learning and memory. | Y | Carlini VP et al. Biochem Biophys Res Commun. 2007;352:907-912. |
| NPS (Neuro-peptide S) | SFRNGVGTGMKKTSFQRAKS (SEQ ID NO:16) | 20 | 2187.5 | intra-cerebroventricular | Mice | enhancement of long-term memory. Enhanced hippocampal-dependent non-aversive memory | Y | Okamura N. et al. Neuropsychopharmacology. 2011 ;36:744-752 |
| CART (Cocaine-and amphetamine-regulated transcript peptide) | | 49 | 5584 | intra-cerebroventricular | Rat | increase of spatial learning and memory | Y | Upadhya MA. et al. Life Sci. 2011;88:322-334 |

These findings make it possible to define a new scheme for the model of visual processing proposed by Beltramo et al. (Science 363, 64-69; 2019).

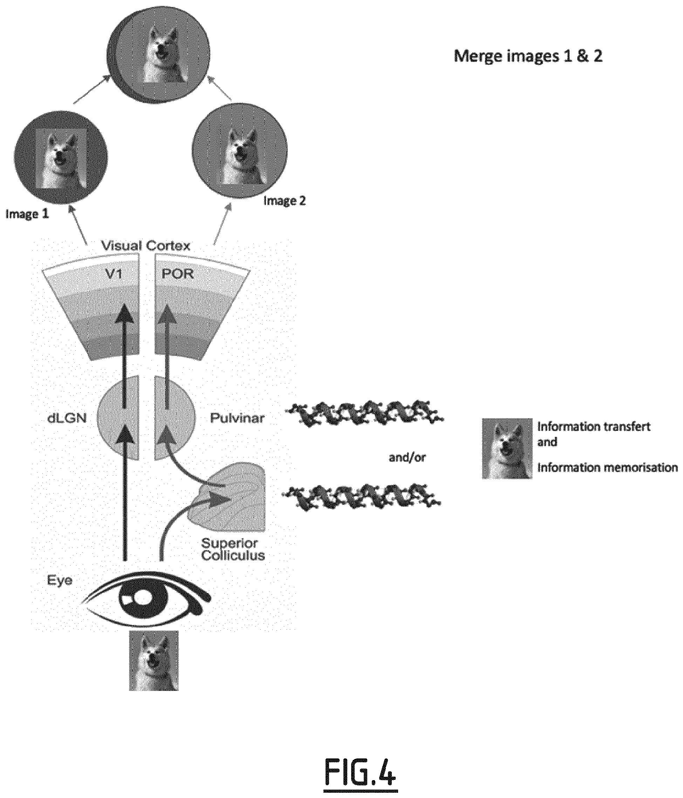

According to the standard model of visual processing, all visual information from the retina must first pass through the primary visual cortex (V1) in the back of the brain (Figure 4), which extracts simple features like lines and edges, before being distributed to a number of "higher order" visual areas that extract increasingly complex features like shapes, shading, movement, and so on.

The study published by Beltramo et al. (Science 363, 64-69; 2019) showed that one of these supposedly higher-order visual areas, which is involved in the perception of moving objects, does not depend on information from V1 at all. Instead, this region, known as the post-rhinal cortex (POR), appears to obtain visual data directly from an evolutionarily ancient sensory processing center at the base of the brain called the superior colliculus.

In the study of Beltramo et al. (Science 363, 64-69; 2019), activity in V1 was temporarily silenced with light, and it was found that POR neurons continued to respond to moving stimuli even without input from V1. So, when the main visual area in the cortex is silenced, the visual responses in POR remained unaffected. If POR's responses to moving objects were not coming from V1, there must be another pathway connecting POR to visual information coming in from the retina. POR neurons were further shown to get two sources of anatomical input - one from V1, and a second from the superior colliculus, each routed through distinct zones of the thalamus, the brain's central relay station.

Based on previous studies, the superior colliculus-POR system could also be linked to fear responses, spatial attention and navigation, or even face recognition - all specialties of the region of temporal cortex where POR is located.

The findings of Beltramo et al. (Science 363, 64-69; 2019) also have implications for the phenomenon called "blindsight," in which people who become blind because of damage to V1 are still able to identify the positions of objects and navigate obstacles, even though they cannot consciously perceive them (J.L. Barbur, L. Weiscrantz, J.A. Harlow, PNAS, 96 (1999), pp. 11637-1164; L. Weiskrantz, J.L. Barbur, A. Sahraie, PNAS, 92 (1995), pp. 6122-6126). Based on studies in primates, blindsight is thought to depend on the superior colliculus, but the results from Beltramo et al. suggest that blindsight could involve POR-like areas of the cortex as well.

In view of our findings and of the foregoing knowledge regarding the pathways involved in visual processing, we conclude that the model of visual processing proposed by Beltramo et al. (Science 363, 64-69; 2019) actually involves (see figure 4):
- Pathway 1: the visual information from the retina pass through the primary visual cortex (V1) which extracts simple features like lines and edges, before being distributed to a number of "higher order" visual areas that extract increasingly complex features like shapes, shading, movement, and so on;
- Pathway 2: the visual information from the retina pass through other parts of the cortex such as postrhinal cortex (POR). The encoded information traverses the neuron to polypeptides having a secondary alpha-helix structure.

This information is encoded in qubits at the level of the alpha helices. The transfer of information can be done through the quantum walk and this, with 100% efficiency within the constitutive network of the alpha-helix.

The phenomenon of quantum recurrence over long times allows both conservation and storage of information.

The information is thus archived, stored within the polypeptides.

At the output of these polypeptides, this information is conventionally decoded into frequency modulation (pulse, square waves ...) to be conveyed to the cortex in order to generate a second image.

According to this model of visual processing, the primary visual cortex (pathway 1) provides an image (image 1) obtained in real time, while pathway 2 solicits an image 2 of the same object if it has been previously stored. A comparison of the image obtained through pathway 1 (image 1) to an image stored in pathway 2 (image 2) will be at the end of the tracks, at the level of the frontal cortex. The concordance (integration and synthesis of the visual perceptions) of the image 1 (in real time) with the image 2 (memorized) generates the recognition of the image, the object, of the face etc. The absence of a stored image 2 during a prior learning process will lead to a failure in the recognition process. The recognition of movements are possible because at time t0 channel 2 has memorized an image. The image from channel 1 perceived in real time at t+1 can therefore be compared with the image stored at t0 by channel 2. If channel 1 is inactivated, at t+1, image 2 can still be compared to image 2 archived at t0 for the perception of movements.

The above conclusions open up real prospects in the field of prevention and treatment of pathologies associated with the processes of vision, but also cognition in the broad sense and those of memory and learning in particular. Moreover, alpha-helix polypeptides could constitute a new means of encoding, transferring and storing quantum information (Quantum memory) in mid-biological and semi-electronic systems (example: biological computer). This renders alpha-helix polypeptides suited for any apparatus for which using a quantum memory is favorable. The apparatus is, for instance, a biological computer, a nanomachine, or a nanorobot. The apparatus is made partially or entirely of alpha-helix polypeptide and thus be used for sensing, actuating or computing.

## Claims

1. Quantum memory (10) comprising:
- a memory space (12) comprising qubits, at least one qubit consisting of at least one polypeptide comprising at least one alpha helix secondary structure.

2. Quantum memory according to claim 1, wherein the ratio between the number of qubits which are a polypeptide comprising at least one alpha helix secondary structure and the total number of qubits is superior or equal to 70%.

3. Quantum memory according to claim 1 or 2, wherein each qubit is a polypeptide comprising at least one alpha helix secondary structure.

4. Quantum memory according to any one of claims 1 to 3, wherein the polypeptide is selected from the group consisting of Plannexin (SEQ ID NO:1), FGL (SEQ ID NO:2), peptide P2 (SEQ ID NO:3), Diptericin B (SEQ ID NO:4), PTEN-PDZ (SEQ ID NO:5), GNBP-Like3 (SEQ ID NO:6), Peptide 6 (SEQ ID NO:7), PTD4-Pl3KAc (SEQ ID NO:8), Substance P (SEQ ID NO:9), Somatostatin (SEQ ID NO:10),, Vasoactive intestinal peptide (SEQ ID NO :11), pituitary adenylate cyclase-activating polypeptide (SEQ ID NO :12), Calcitonin gene-related peptide (SEQ ID NO :13), Ghrelin (SEQ ID NO :14), Obestatin (SEQ ID NO :15), Neuro-peptide S (SEQ ID NO:16), and Cocaine- and amphetamine-regulated transcript peptide (SEQ ID NO :17).

5. Quantum memory according to any one of claims 1 to 4, wherein the memory space (12) comprises less than 100 qubits, preferably less than 20 qubits.

6. Quantum memory according to any one of claims 1 to 5, wherein the memory space (12) comprises several identical pairs of qubits.

7. Apparatus, notably a quantum computer, comprising at least one quantum memory (12) according to any one of claims 1 to 6.

## Patentansprüche

1. Quantenspeicher (10), umfassend:
- einen Speicherraum (12), umfassend Qubits, wobei mindestens ein Qubit aus mindestens einem Polypeptid besteht, das mindestens eine Alpha-Helix-Sekundärstruktur umfasst.

2. Quantenspeicher nach Anspruch 1, wobei das Verhältnis zwischen der Anzahl von Qubits, die ein Polypeptid sind, das mindestens eine Alpha-Helix-Sekundärstruktur umfasst, und der Gesamtanzahl von Qubits größer oder gleich 70 % ist.

3. Quantenspeicher nach Anspruch 1 oder 2, wobei jedes Qubit ein Polypeptid ist, das mindestens eine Alpha-Helix-Sekundärstruktur umfasst.

4. Quantenspeicher nach einem der Ansprüche 1 bis 3, wobei das Polypeptid ausgewählt ist aus der Gruppe bestehend aus Plannexin (SEQ ID NO:1), FGL (SEQ ID NO:2), Peptid P2 (SEQ ID NO:3), Diptericin B (SEQ ID NO:4), PTEN-PDZ (SEQ ID NO:5), GNBP-Like3 (SEQ ID NO:6), Peptid 6 (SEQ ID NO:7), PTD4-PI3KAc (SEQ ID NO:8), Substanz P (SEQ ID NO:9), Somatostatin (SEQ ID NO:10), vasoaktivem intestinalem Peptid (SEQ ID NO:11), hypophysärem Adenylatcyclase-aktivierendem Polypeptid (SEQ ID NO:12), Calcitonin-Gen-verwandtem Peptid (SEQ ID NO:13), Ghrelin (SEQ ID NO:14), Obestatin (SEQ ID NO:15), Neuro-Peptid S (SEQ ID NO:16), und Cocain- und Amphetamin-reguliertem Transkript-Peptid (SEQ ID NO:17).

5. Quantenspeicher nach einem der Ansprüche 1 bis 4, wobei der Speicherraum (12) weniger als 100 Qubits, vorzugsweise weniger als 20 Qubits, umfasst.

6. Quantenspeicher nach einem der Ansprüche 1 bis 5, wobei der Speicherraum (12) mehrere identische Paare von Qubits umfasst.

7. Vorrichtung, insbesondere ein Quantencomputer, umfassend mindestens einen Quantenspeicher (12) nach einem der Ansprüche 1 bis 6.

## Revendications

1. Mémoire quantique (10) comprenant :
- un espace mémoire (12) comprenant des qubits, au moins un qubit étant constitué d'au moins un polypeptide comprenant au moins une structure secondaire en hélice alpha.

2. Mémoire quantique selon la revendication 1, dans laquelle le rapport entre le nombre de qubits qui sont un polypeptide comprenant au moins une structure secondaire en hélice alpha et le nombre total de qubits est supérieur ou égal à 70 %.

3. Mémoire quantique selon la revendication 1 ou 2, dans laquelle chaque qubit est un polypeptide comprenant au moins une structure secondaire en hélice alpha.

4. Mémoire quantique selon l'une quelconque des revendications 1 à 3, dans laquelle le polypeptide est choisi parmi le groupe constitué de Plannexin (SEQ ID NO:1), FGL (SEQ ID NO:2), peptide P2 (SEQ ID NO:3), Diptericin B (SEQ ID NO:4), PTEN-PDZ (SEQ ID NO:5), GNBP-Like3 (SEQ ID NO:6), Peptide 6 (SEQ ID NO:7), PTD4-PI3KAc (SEQ ID NO:8), Substance P (SEQ ID NO:9), Somatostatine (SEQ ID NO:10), peptide intestinal vasoactif (SEQ ID NO:11), polypeptide activateur de l'adénylate cyclase hypophysaire (SEQ ID NO:12), peptide relié au gène de la calcitonine (SEQ ID NO:13), Ghréline (SEQ ID NO:14), Obestatine (SEQ ID NO:15), Neuropeptide S (SEQ ID NO:16), et peptide du transcrit régulé par la cocaïne et l'amphétamine (SEQ ID NO:17).

5. Mémoire quantique selon l'une quelconque des revendications 1 à 4, dans laquelle l'espace mémoire (12) comprend moins de 100 qubits, de préférence moins de 20 qubits.

6. Mémoire quantique selon l'une quelconque des revendications 1 à 5, dans laquelle l'espace mémoire (12) comprend plusieurs paires identiques de qubits.

7. Appareil, notamment un ordinateur quantique, comprenant au moins une mémoire quantique (12) selon l'une quelconque des revendications 1 à 6.
